# EUROPEAN PATENT SPECIFICATION

(11) **EP 0 997 937 B1**
(45) Date of publication and mention of the grant of the patent: **15.10.2003**
(21) Application number: 99308498.7
(22) Date of filing: 27.10.1999
(51) Int. Cl.: H01L 23/367, H01L 25/065

(54) **Semiconductor device module with a heat sink**
Halbleitermodul mit einem Kühlkörper
Module semi-conducteur muni d'un dissipateur thermique

(30) Priority: 28.10.1998 JP 30735298
(43) Date of publication of application: 03.05.2000
(73) Proprietor: SHINKO ELECTRIC INDUSTRIES CO. LTD., Nagano-shi, Nagano 380-0921 (JP)
(72) Inventor: Higashi, Mitsutoshi, Shinko Electric Ind. Co., Ltd, Nagano-shi, Nagano 380-0921 (JP); Koike, Hiroko, Shinko Electric Ind. Co., Ltd, Nagano-shi, Nagano 380-0921 (JP)
(74) Representative: Rackham, Stephen Neil

(56) References cited:
- EP-A- 0 359 928
- EP-A- 0 528 606
- US-A- 5 476 211
- US-A- 5 572 070
- PATENT ABSTRACTS OF JAPAN vol. 1996, no. 07, 31 July 1996 (1996-07-31) -& JP 08 078584 A (HITACHI LTD), 22 March 1996 (1996-03-22)
- PATENT ABSTRACTS OF JAPAN vol. 014, no. 112 (E-0897), 28 February 1990 (1990-02-28) -& JP 01 310566 A (MITSUBISHI ELECTRIC CORP), 14 December 1989 (1989-12-14)
- PATENT ABSTRACTS OF JAPAN vol. 1997, no. 03, 31 March 1997 (1997-03-31) -& JP 08 306832 A (MITSUBISHI ELECTRIC CORP), 22 November 1996 (1996-11-22)

## Description

### BACKGROUND OF THE INVENTION

The present invention relates to a semiconductor device module and a semiconductor device module part and, more particularly, to such a module and a module part, including a plurality of semiconductor devices mounted on a mounting board, each device including a semiconductor element having one surface on which electrode terminals are formed, pads formed on the same surface, and wires provided at an intermediate portion thereof with a bent portion and connected by its one end to a terminal on the mounting board.

A chip-sized semiconductor package (CSP), i.e., a semiconductor device which has a substantially same size as that of a semiconductor chip, has been known in the prior art, such as disclosed in U.S. Patent No. 5,476,211. Such a known CSP is shown in Fig. 3, in which CPS 2 includes a semiconductor chip 10 having one surface, i.e., an electrode forming surface, on which formed are electrode terminals and re-wiring pads 12 to which one ends of wires 14 are connected. Each of the wires 14 is flexible, since it has a bent portion at an intermediate position thereof. The other end 16 of the wire 14 is to be connected to a terminal on a mounting board.

Fig. 4 shows a semiconductor device module in which a plurality of CSPs 2 are mounted on the mounting board 18. The semiconductor device module shown in Fig. 4 includes a plurality of CSPs 2 each of which is connected to a pad 20, as a terminal, on the mounting board 18 via a wire 14. Connection between the wire 14 and the pad 20 is conducted by means of a solder 22.

The bent portion of the wire 14 reduces the thermal stress exerted on both the semiconductor element 10 and the mounting board 18, caused by the difference in thermal expansion coefficient therebetween. In order to allow the wire to be expanded or contracted, a space is kept between the semiconductor element 10 and the mounting board 18.

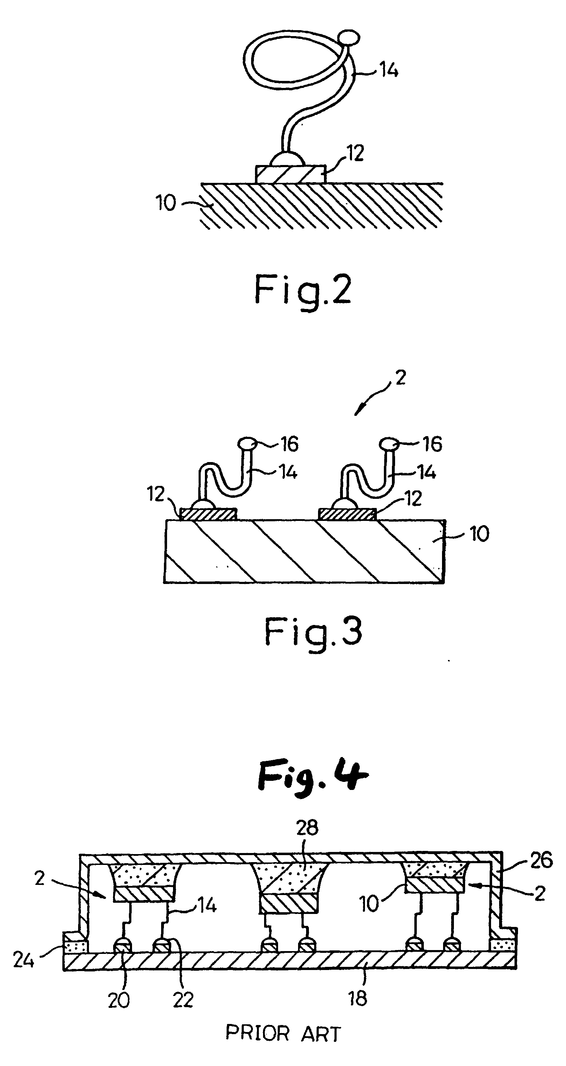

On the other hand, since there is a space between the semiconductor element 10 and the mounting board 18, it is difficult to improve the efficiency of heat radiation from the electrode forming surface of the semiconductor element 10. Thus, the inventors have made an arrangement in which, in order to improve a heat radiation from the other surface of the semiconductor element 10, a peripheral edges of recessed portion of a heat spreader 26 is first adhered to a surface of the mounting board 18 by means of an adhesive layer 24 and, then, a bottom of the recessed portion of the heat spreader 26 are arranged to face to the other surfaces of the semiconductor elements 10 which constitute respective CSP5 2, 2, 2, ... , as shown in Fig. 3. In addition, the inventors filled a thermal conductive resin 28 containing fillers of non-organic material, such as alumina, silica or the others, into a region between the bottom of the recessed heat spreader 26 and the other surface of the semiconductor element 10, to improve the thermal conductivity.

Thermal conductivity of the semiconductor device module shown in Fig. 4 can be improved as compared with that of a semiconductor device module having only a space between the bottom of the recessed heat spreader 26 and the other surface of the semiconductor element 10.

However, the length of the wires for connecting the respective pads 20 of the mounting board 18 to the pads 12 of the semiconductor element 10 is variable among the respective CSPs 2, 2, 2, ... and among the same CSP 2, since the respective wires have respective bent portions. Therefore, the positions of the other surfaces of the semiconductor elements 12 of the CSP 2 mounted on the mounting board 18 are different for the respective CSPs 2 and, therefore, the thickness of the thermal conductive resin 28 filled on the other surface of the semiconductor element 10 is variable so that the level of the thermal conductivity is different for the respective CSPs 2. Thus, a heat accumulated portion may be generated in the semiconductor device module shown in Fig. 4 and may cause error operations.

In the CSP 2 shown in Fig. 3, the wires 14 extend upward from the pads 12 of the semiconductor elements 10. Therefore, during assembling process of the semiconductor device module, wires 14 of CSP 2 may interfere with the other wires 14 or other parts and may thus be damaged. The wire could be transferred together but handing of wires would then be troublesome.

JP-A-8078584 discloses an electronic package in which the back surface of an electronic device is adhered to a heat sink by means of a thermally conductive contact layer and legs of the heat sink are adhered to a circuit board. The electronic device is electrically connected to the circuit board by means of a flexible wiring layer.

EP-A-0528606 discloses a thermally conductive interface material for adhesively connecting an electronic device to a heat sink.

JP-A-1310566 discloses a semiconductor device in which a spring is provided on the inner surface of the heat spreading cap for contacting the surface of an electrode on the upper surface of a semiconductor chip. The spring acts as an additional heat transfer path from the semiconductor chip.

An object of the present invention is to provide a semiconductor device module part, capable of absorbing the thermal stress caused by the difference in thermal expansion coefficient between a semiconductor device and a mounting board on which a semiconductor device is mounted, capable of obtaining a uniform heat radiation from the respective semiconductor devices, and capable of easily assembling and handling the semiconductor devices.

Accordingly, the invention consists in a semiconductor device module part including at least one semiconductor device comprising a semiconductor element having first and second surfaces and pads formed on said first surface and connected to electrode terminals of the semiconductor element,
a cap shaped heat spreader having a recessed inner wall provided with a peripheral edge which is adapted to be adhered to or engaged with a mounting board which faces the first surface of the at least one semiconductor element; and
a thermally conductive resin layer disposed between said second surface of the semiconductor element and the surface of the recessed inner wall of the heat spreader;
characterised by curved flexible wires each having one end fixed to one of said pads and provided with a bent portion at an intermediate position thereof; and
wherein an inside region of the recessed inner wall of the heat spreader is filled with sealing resin in such a manner that said first surface of the semiconductor element is covered with the sealing resin and the wires protrude from a surface of said sealing resin.

Preferably, the peripheral edge of the heat spreader is adhered to the mounting board by means of an elastic resin to absorb a difference in thermal expansion due to a difference in thermal expansion coefficient therebetween.

Preferably, the thermal conductive resin layer is provided for the respective semiconductor element.

Preferably, the thermal conductive resin layer is a film made of thermal conductive resin.

Preferably, the thermal conductive resin layer is made of a resin containing therein fillers made of non-organic material, such as alumina, silica or the like, and/or fillers made of metallic material, such as aluminum, copper or the like.

Particular embodiments in accordance with this invention will now be described with reference to the accompanying drawings; in which:
Figs. 1(a) and 1(b) show a process for fabricating a semiconductor device module, including a module part, according to the present invention;
Fig. 2 shows a wire which can be used in this invention;
Fig. 3 shows another embodiment of wire which can be used in this invention; and
Fig. 4 is a cross-sectional view of a semiconductor device module known in the prior art;

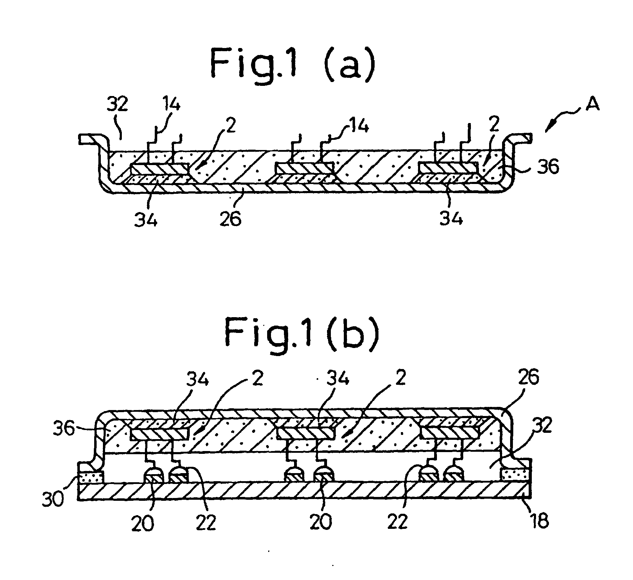

A semiconductor device module including the invention can be used as a memory module. An embodiment of such a memory module is shown in Fig. 1(b) which includes a plurality of semiconductor devices, i.e., a plurality of CSP 2, such as shown in Fig. 3.

The CSP 2, 2, 2, ... are mounted on a mounting board 18 mainly made of resin. That is to say, a semiconductor chip 10 constituting respective CSPs 2 has one surface, i.e., an electrode forming surface, on which are formed electrode terminals and re-wiring pads 12 to which one ends of wires 14 are connected. Each of the wires 14 is flexible, since it has a bent portion at an intermediate position thereof. The other end of the wire 14 is connected to a pad 20 on the mounting board 18.
Connection between the other end of the wire 14 and the pad 20 of the mounting board 18 is conducted by means of a solder 22.

A cap-shaped heat spreader 26 made of metal, such as a copper, aluminum or the other, is arranged on the other side of the respective CSP 2, 2, 2, ... mounted on the mounting board 18 (the opposite side of the electrode forming surface of the semiconductor element 10). The heat spreader 26 has a peripheral edges of recessed portion 32 which is adhered to a surface of the mounting board 18 by means of adhesive layer 30 and defines a recessed inner portion 32. A bottom of the recessed inner portion 32 faces to the other surfaces of the semiconductor elements 10.

The adhesive layer 30 is preferably a low elastic resin, the elasticity coefficient of Young's modulus thereof being lower than 100 MPa at room temperature, to make it possible to absorb the difference in the thermal conductivity due to the difference of the thermal expansion coefficient between the heat spreader 26 made of metal and the mounting board 18 mainly made of resin. Such a low elastic resin may be a silicone or fluororesin rubber, polyorephyne elastomer, epoxy resin dispersed with rubber such as NBR, or others.

Thermal conductive resin layers 34, 34, 34, ... made of thermal conductive resin are formed between the bottom of the recessed inner portion 32 and the other surfaces of the semiconductor elements 10. Thus, heat generated in the semiconductor elements 10 is transmitted through the thermal conductive resin layers 34 to the heat spreader 26 and, therefore, the thermal conductivity can be improved as compared with a semiconductor device module having no such thermal conductive resin layers 34.

The respective thermal conductive resin layers 34, 34, 34, ... have a same thickness and, therefore, the amount of heat radiated from the respective semiconductor elements to the heat spreader 26 can thus be a uniform value. Thus, any heat accumulated portion would not be formed within the semiconductor device module and thus a heat radiation efficiency can be improved.

The thermal conductive resin which forms the thermal conductive resin layers 34 may be a resin containing fillers of non―organic material, such as alumina, silica or the others, and/or metal fillers, such as aluminum, copper or the others.

The thickness of the thermal conductive resin layers 34, 34, 34, ... may be variable as far as the amount of heat radiated from the respective semiconductor elements 10 to the heat spreader 26 can be a uniform value.

The semiconductor device module shown in Fig. 1(b) can be made by using a semiconductor device module part A as shown in Fig. 1(a). The module part A includes the heat spreader 26 having a bottom to which the other surfaces of the semiconductor elements 10 are adhered by means of the thermal conductive resin layers 34.

In the module part A, the thermal conductive resin layers 34 for adhering the other surfaces of the semiconductor elements 10 to the bottom of the heat spreader 26 have substantially the same thickness. Therefore, in the module part A, the lengths of the respective wires 14 are different with respect to each other. The respective wire 14 is provided at an intermediate portion thereof with a bent portion. Therefore, it is very difficult to make the height of wires uniform.

Since the wire 14 has a bent portion at an intermediate portion thereof, the wire 14 can easily be bent and has an effective resilience. As shown in Fig. 1(b), when the peripheral edge of the recess 32 of the heat spreader 26 is adhered to the mounting board 18 by means of an adhesive layer 30, the other ends of the respective wires 14 can be connected to the pads 20 on the mounting board 18. In other words, a wire 14 which is higher than the other wires can be pushed between the semiconductor element 10 and the mounting board 18 while the bent portion thereof resiliently deforms to regulate the length of that wire, until the other lower wires 14 are brought into contact with the respective pads 20 on the mounting board 18.

In the semiconductor device module part A shown in Fig. 1(a), almost all of the CSPs 2 which are adhered to the bottom of the spreader 26 are accommodated in the inside of the recess 32. Therefore, when the semiconductor device module part A is transported or stored in its state, the wires 14 may not interfere with wires of the other CSP 2 or the other parts, as compared when a CSP 2 is transported or stored by its own state. Therefore, the semiconductor device module can easily be made and the cost of production thereof can be reduced.

In the semiconductor device module part A and the module as shown in Figs. 1(a) and 1(b), a sealing resin 36 is filled by potting or the other process within the recess 32 of the heat spreader 26 so as to completely cover the semiconductor elements 10 mounted on the bottom of the recess 32 of the heat spreader 26 to hermetically seal these semiconductor elements 10.

The bent portions of the wires 14 are protruded from an upper surface of the sealing resin 36. If the bent portions of the wires 14 were sealed in the sealing resin 36, it would become difficult to regulate the height of the respective wires 14 when the semiconductor device module part A is mounted on the mounting board 18 as shown in Fig. 1(b).

In the semiconductor device module as shown in Fig. 1(b), the other ends of the wires of the CSP 2, 2, 2, ... are fixed to the pads 20 of the mounting board 18 by means of solder 22. However, solder 22 may not necessarily be used. The wire has a resilient property due to its bent portion, so that the other end of the wire 14 is always pushed toward the pad 20 on the mounting board 18 owing to the resilient property of the wire itself.

In the embodiments shown in Figs. 1(a) and 1(b) , the respective CSPs 2, 2, 2, ... and the recessed bottom of the heat spreader 26 are adhered to each other by means of thermal conductive resin layers 34 formed for the respective CSPs 2. However, a film of thermal conductive resin can be used to cover the whole area of the recessed bottom of the heat spreader 26. In such a semiconductor device module part A having the thermal conductive resin layer a double-sided adhesive film made of thermal conductive resin can be used to adhere, by one side thereof, to the recessed bottom of the heat spreader 26 and by the other side thereof to the respective CSP 2, 2, 2, ...

The wire 14 which can be used in the CSP 2 may be a helical wire such as shown in Fig.2 in place of a hair pin-shaped wire including two bent portions as shown in Fig. 3.

In CSP 2 such as shown in Figs. 2 and 3, wiring on the one surface of the semiconductor element 10 is provided with a pad 12 to which one end of the wire 14 is connected. However, the wire 14 can be directly connected to the electrode terminal of the semiconductor element 10.

## Claims

1. A semiconductor device module part (A) including at least one semiconductor device (2) comprising a semiconductor element (10) having first and second surfaces and pads (12) formed on said first surface and connected to electrode terminals of the semiconductor element (10),
a cap shaped heat spreader (26) having a recessed inner wall provided with a peripheral edge which is adapted to be adhered to or engaged with a mounting board (18) which faces the first surface of the at least one semiconductor element (10); and
a thermally conductive resin layer (34) disposed between said second surface of the semiconductor element (10) and the surface of the recessed inner wall of the heat spreader (26);
**characterised by** curved flexible wires (14) each having one end fixed to one of said pads (12) and provided with a bent portion at an intermediate position thereof; and
wherein an inside region of the recessed inner wall of the heat spreader (26) is filled with sealing resin (36) in such a manner that said first surface of the semiconductor element (10) is covered with said sealing resin (36) and said wires (14) protrude from a surface of said sealing resin (36).

2. A semiconductor device module part (A) according to claim 1, wherein a plurality of semiconductor devices (2) comprising respective semiconductor elements (10) are provided and the second surface of each element (10) is adhered to the surface of said recessed inner wall of the heat spreader (26).

3. A semiconductor device module part (A) according to claim 1 or claim 2, wherein said second surface of the semiconductor element (10) is adhered to said surface of said recessed inner wall of the heat spreader (26) by means of a thermally conductive adhesive layer (34).

4. A semiconductor device module part (A) according to any one of the preceding claims, wherein said thermally conductive resin layer (34) is provided for each respective semiconductor element (10), or wherein said thermally conductive resin layer is a single continuous film made of thermally conductive resin.

5. A semiconductor device module part (A) according to any one of the preceding claims, wherein said thermally conductive resin layer (34) is made of a resin containing therein fillers made of non-organic material, and/or fillers made of metallic material.

6. A semiconductor device module part (A) according to any one of the preceding claims, wherein said peripheral edge of the heat spreader (26) is adhered to said mounting board (18) by means of an elastic resin (30) to absorb a difference in thermal expansion due to a difference in thermal expansion coefficient therebetween.

7. A semiconductor device module part (A) according to any one of the preceding claims, wherein the curved flexible wires (14), when not deformed, extend a non-uniform height from the first surfaces of the semiconductor elements (10) and when the heat spreader (26) is adhered to or engaged with the mounting board (18) the curved flexible wires (14) each sufficiently deform so that each flexible wire (14) contacts a pad (20) on the mounting board (18).

8. A semiconductor device module part (A) according to any one of the preceding claims, wherein the thickness of the thermally conductive resin layer (34) is the same between each semiconductor element (10) and the heat spreader (26).

## Patentansprüche

1. Halbleiterbauelementmodulteil (A) mit
wenigstens einem Halbleiterbauelement (2), das ein Halbleiterelement (10) mit einer ersten und einer zweiten Oberfläche und Kontaktstellen (12) umfasst, die an der ersten Oberfläche ausgebildet und mit Elektrodenanschlüssen des Halbleiterbauelements (10) verbunden sind,
einem haubenförmigen Wärmeableitelement (26) mit einer vertieften Innenwand, die mit einer Umfangskante versehen ist, die dafür eingerichtet ist, an einer Montageplatine (18), welche der ersten Oberfläche des wenigstens einen Halbleiterelementes (10) gegenüberliegt, angebracht oder in Verbindung gebracht zu werden, und
einer wärmeleitfähigen Harzschicht (34), die zwischen der zweiten Oberfläche des Halbleiterelementes (10) und der Oberfläche der vertieften Innenwand des Wärmeableitelements (26) angeordnet ist,
**gekennzeichnet durch**
gekrümmte flexible Drähte (14), von denen jeder mit einem Ende an einer der Kontaktstellen (12) festgelegt ist und mit einem gebogenen Abschnitt an einer zwischenliegenden Position desselben versehen ist,
wobei ein innerer Bereich der vertieften Innenwand des Wärmeableitelements (26) mit abdichtendem Harz (36) derart gefüllt ist, dass die erste Oberfläche des Halbleiterelements (10) mit dem abdichtenden Harz (36) bedeckt ist und die Drähte (14) von einer Oberfläche des abdichtenden Harzes (36) vorstehen.

2. Halbleiterbauelementmodulteil (A) nach Anspruch 1, wobei eine Mehrzahl von Halbleiterbauelementen (2) mit jeweiligen Halbleiterelementen (10) vorgesehen ist und die zweite Oberfläche jedes Elements (10) an der Oberfläche der vertieften Innenwand des Wärmeableitelements (26) angebracht ist.

3. Halbleiterbauelementmodulteil (A) nach Anspruch 1 oder Anspruch 2, wobei die zweite Oberfläche des Halbleiterelements (10) an der Oberfläche der vertieften Innenwand des Wärmeableitelements (26) mittels einer wärmeleitfähigen Klebeschicht (34) angebracht ist.

4. Halbleiterbauelementmodulteil (A) nach einem der vorhergehenden Ansprüche, wobei die wärmeleitfähige Harzschicht (34) für jedes Halbleiterelement (10) vorgesehen ist oder wobei die wärmeleitfähige Harzschicht ein einzelner kontinuierlicher Film aus wärmeleitfähigem Harz ist.

5. Halbleiterbauelementmodulteil (A) nach einem der vorhergehenden Ansprüche, wobei die wärmeleitfähige Harzschicht (34) aus einem Harz besteht, das Füllstoffe aus nicht-organischem Material und/oder Füllstoffe aus metallischem Material darin enthält.

6. Halbleiterbauelementmodulteil (A) nach einem der vorhergehenden Ansprüche, wobei die Umfangskante des Wärmeableitelements (26) an der Montageplatine (18) mittels eines elastischen Harzes (30) angebracht ist, um einen Unterschied in der thermischen Ausdehnung aufgrund eines Unterschieds im thermischen Ausdehnungskoeffizienten dazwischen zu absorbieren.

7. Halbleiterbauelementmodulteil (A) nach einem der vorhergehenden Ansprüche, wobei sich die gekrümmten flexiblen Drähte (14) im nicht deformierten Zustand in ungleicher Höhe von den ersten Oberflächen der Halbleiterelemente (10) erstrecken und jeder der gekrümmten flexiblen Drähte (14), wenn das Wärmeableitelement (26) an der Montageplatine (18) angebracht oder mit diesem in Verbindung gebracht wird, ausreichend deformiert wird, so dass jeder flexible Draht (14) eine Kontaktstelle (20) auf der Montageplatine (18) kontaktiert.

8. Halbleiterbauelementmodulteil (A) nach einem der vorhergehenden Ansprüche, wobei die Dicke der wärmeleitfähigen Harzschicht (34) zwischen jedem Halbleiterelement (10) und dem Wärmeableitelement (26) gleich ist.

## Revendications

1. Module (A) de dispositif à semi-conducteurs incluant au moins un dispositif à semi-conducteurs (2) comprenant un élément à semi-conducteurs (10) ayant une première et une seconde surfaces et des pastilles (12) formées sur ladite première surface et connectées à des bornes d'électrodes de l'élément à semi-conducteurs (10),
un dissipateur de chaleur (26) en forme de capot présentant une paroi interne en creux, pourvue d'un bord périphérique qui est adapté pour être collé à, ou à s'engager sur une plaquette de montage (18) qui fait face à la première surface de l'élément à semi-conducteurs (10) au moins présent ; et
une couche de résine (34) conductrice thermique, disposée entre ladite seconde surface de l'élément à semi-conducteurs (10) et la surface de la paroi interne en creux du dissipateur de chaleur (26) ;
**caractérisé par** des fils (14) flexibles, courbés, présentant chacun une extrémité fixée à l'une desdites pastilles (12) et pourvus d'une portion pliée, dans une position intermédiaire; et
dans lequel une zone intérieure de la paroi interne en creux du dissipateur de chaleur (26) est remplie d'une résine de scellement (36) d'une manière telle que ladite première surface de l'élément à semi-conducteurs (10) est recouverte par ladite résine de scellement (36) et que lesdits fils (14) fassent saillie depuis une surface de ladite résine de scellement (36).

2. Module (A) de dispositif à semi-conducteurs selon la revendication 1, dans lequel plusieurs dispositifs à semi-conducteurs (2) comprenant des éléments à semi-conducteurs (10) respectifs, sont prévus, et la seconde surface de chaque élément (10) est collée à la surface de ladite paroi interne en creux du dissipateur de chaleur (26).

3. Module (A) de dispositif à semi-conducteurs selon la revendication 1 ou la revendication 2, dans lequel ladite seconde surface de l'élément à semi-conducteurs (10) est collée à ladite surface de ladite paroi interne en creux du dissipateur de chaleur (26) au moyen d'une couche adhésive (34) conductrice thermique.

4. Module (A) de dispositif à semi-conducteurs selon l'une quelconque des revendications précédentes, dans lequel ladite couche de résine (34) conductrice thermique est prévue pour chaque élément à semi-conducteurs respectif (10), ou dans lequel ladite couche de résine conductrice thermique est un film continu, unique, fait d'une résine conductrice thermique.

5. Module (A) de dispositif à semi-conducteurs selon l'une quelconque des revendications précédentes, dans lequel ladite couche de résine (34) conductrice thermique est faite d'une résine contenant des charges faites de matériau non organique, et/ou de charges faits de matériau métallique.

6. Module (A) de dispositif à semi-conducteurs selon l'une quelconque des revendications précédentes, dans lequel ledit bord périphérique du dissipateur de chaleur (26) est collé à ladite plaquette de montage (18) au moyen d'une résine élastique (30) destinée à absorber une différence dans la dilatation thermique, due à une différence entre les coefficients de dilatation thermique de ces parties.

7. Module (A) de dispositif à semi-conducteurs selon l'une quelconque des revendications précédentes, dans lequel les fils flexibles courbés (14), lorsqu'ils ne sont pas déformés, s'étendent sur une hauteur non uniforme depuis les premières surfaces des éléments à semi-conducteurs (10) et lorsque le dissipateur de chaleur (26) est collé à, ou s'engage sur la plaquette de montage (18), les fils flexibles courbés (14) se déforment chacun suffisamment pour que chaque fil flexible (14) entre en contact avec une pastille (20) de la plaquette de montage (18).

8. Module (A) de dispositif à semi-conducteurs selon l'une quelconque des revendications précédentes, dans lequel l'épaisseur de la couche de résine (34) conductrice thermique est la même entre chaque élément à semi-conducteurs (10) et le dissipateur de chaleur (26).
